# EUROPEAN PATENT APPLICATION

(11) **EP 4 651 677 A1**
(43) Date of publication of application: **19.11.2025**
(21) Application number: 24919171.9
(22) Date of filing: 13.11.2024
(51) Int. Cl.: H10F 19/90, G01K 11/12, H10F 19/80, H10F 77/30, H02M 7/493

(54) **SOLAR CELL MODULE AND POWER GENERATION SYSTEM**

(30) Priority: 29.03.2024 KR 20240043734
(71) Applicant: Hanwha Solutions Corporation, Jung-gu Seoul 04541 (KR)
(72) Inventor: KANG, Youn Jong, Seoul 04541 (KR); PARK, Gi Yob, Seoul 04541 (KR); JUNG, Kyung Su, Seoul 04541 (KR); LEE, Su Chang, Seoul 04541 (KR); YUN, Ju Hwan, Seoul 04541 (KR)
(74) Representative: Mooser, Sebastian Thomas
(86) International application number: PCT/KR2024/017904
(87) International publication number: WO 2025/206507

(57) **Abstract**

The present disclosure provides a solar cell module including a plurality of cells, an electrode ribbon configured to connect the plurality of cells, a sealing unit configured to seal the plurality of cells, a frame disposed on one surface of the sealing unit, and a backsheet configured to support another surface of the sealing unit, wherein the electrode ribbon includes a first indicator of which a color changes according to a temperature change of the plurality of cells.

## Description

### Technical Field

The present disclosure relates to a solar cell module and a power generation system.

### Background Art

Solar cells, which are attracting attention as alternative energy sources today, are a type of photovoltaic devices that convert sunlight into electrical energy by using a photoelectric conversion effect. In order to produce electricity through solar cells while maintaining usability and long-term durability/reliability, the solar cells are manufactured in the form of modules.

Solar cell modules cannot produce electricity normally due to defects that occur during the manufacturing of cells or modules or failures or defects that occur in power conversion systems after installation, resulting in a reduction in power generation efficiency. For example, when a solar cell module is partially covered or is partially deteriorated or disconnected to cause an output imbalance, a hotspot phenomenon may occur in which a module is overheated. A hotspot phenomenon may damage glass or a backsheet of a module and may reduce power generation efficiency.

In this way, detecting modules that do not normally operate in solar power generation is a very important issue, but in module level power electronics (MLPE) systems that control power conversion in units of modules, it is difficult to detect solar modules that do not normally operate.

### Disclosure

### Technical Problem

The present disclosure is directed to providing a solar cell module and a power generation system in which, in a power generation system in which a module level power electronics (MLPE) device is installed, a temperature for each module is visually displayed to check a power generation amount or operating state of a solar cell module. The present disclosure is directed to providing a solar cell module and a power generation system in which, in a power generation system in which a module level power electronics (MLPE) device is installed, a temperature for each module is visually displayed to check a power generation amount or operating state of a solar cell module.

### Technical Solution

An aspect of the present disclosure provides a solar cell module including a plurality of cells, an electrode ribbon configured to connect the plurality of cells, a sealing unit configured to seal the plurality of cells, a frame disposed on one surface of the sealing unit, and a backsheet configured to support another surface of the sealing unit, wherein the electrode ribbon includes a first indicator of which a color changes according to a temperature change of the plurality of cells.

### Advantageous Effects

In a solar cell module according to embodiments of the present disclosure, a power generation amount or an operating state of a module may be visually and easily checked by using an indicator that changes color when a temperature change of the module is detected.

In a solar cell module according to embodiments of the present disclosure, whether there is a failure or defect may be quickly determined without use of separate diagnostic device or a communication device, thereby improving productivity and efficiency and enabling the continuous operation of a power generation system.

### Description of Drawings

FIG. 1 is a schematic exploded perspective view illustrating a solar cell module according to an embodiment of the present disclosure.
FIG. 2 is a view illustrating a cross section of a cell and an electrode ribbon of FIG. 1, which is taken along line II-II'.
FIGS. 3A and 3B are views illustrating a cell and an electrode ribbon according to an embodiment.
FIGS. 4A to 4C are views illustrating a cell and an electrode ribbon according to another embodiment.
FIG. 5 is a view illustrating a solar cell array in which a plurality of solar cell modules of FIG. 1 are arranged.
FIG. 6 is a view illustrating a cross section of a solar cell module according to another embodiment, which is taken along line VI-VI' of FIG. 1.
FIG. 7 is a view illustrating a solar cell array in which a plurality of solar cell modules of FIG. 6 are arranged.
FIG. 8 is a view illustrating a solar cell power generation system including the solar cell module of FIG. 1.

### Best Mode

An aspect of the present disclosure provides a solar cell module including a plurality of cells, an electrode ribbon configured to connect the plurality of cells, a sealing unit configured to seal the plurality of cells, a frame disposed on one surface of the sealing unit, and a backsheet configured to support another surface of the sealing unit, wherein the electrode ribbon includes a first indicator of which a color changes according to a temperature change of the plurality of cells.

In addition, the first indicator may exhibit a first color in a first temperature range and may exhibit a second color different from the first color in a second temperature range different from the first temperature range.

In addition, the first indicator may be applied onto a surface of the electrode ribbon.

In addition, the first indicator may exhibit a first color when the cell normally operates, may exhibit a second color when the cell does not operate, and may exhibit a third color when the cell abnormally operates.

In addition, the first indicator may change from a first color to a second color in one area of the electrode ribbon and may change from the first color to a third color in another area of the electrode ribbon.

In addition, the solar cell module may further include a module level power electronics (MLPE) device connected to the cell.

Another aspect of the present disclosure provides a solar cell module including a plurality of cells, an electrode ribbon configured to connect the plurality of cells, a sealing unit configured to seal the plurality of cells, a frame disposed on one surface of the sealing unit, and a backsheet configured to support another surface of the sealing unit, wherein the frame includes a second indicator of which a color changes according to a temperature change of the plurality of cells.

In addition, the second indicator may exhibit a first color in a first temperature range and may exhibit a second color different from the first color in a second temperature range different from the first temperature range.

In addition, the second indicator may be applied onto a surface of the frame.

In addition, the second indicator may exhibit a first color when the cell normally operates, may exhibit a second color when the cell does not operate, and may exhibit a third color when the cell abnormally operates.

In addition, the second indicator may change from a first color to a second color in one area of the frame and may change from the first color to a third color in another area of the frame.

In addition, the solar cell module may further include a MLPE device connected to the cell.

### Mode for Invention

Since the present disclosure can apply various transformations and have various embodiments, specific embodiments will be illustrated in the drawings and described in detail in the detailed description. Effects and features of the present disclosure, and methods for achieving them will become clear with reference to the embodiments described below in detail together with the drawings. However, the present disclosure is not limited to the embodiments disclosed below and may be implemented in various forms.

Hereinafter, embodiments of the present disclosure will be described in detail with reference to the attached drawings. When describing with reference to the drawings, identical or corresponding components are given the same drawing reference numerals and redundant descriptions thereof are omitted.

In the following embodiments, the terms first, second, and the like do not have limited meaning but are used for the purpose of distinguishing one component from another component.

In the following embodiments, the expressions used in the singular such as "a," "an," and "the" are intended to include the plural forms as well, unless the context clearly indicates otherwise.

In the following embodiments, it will be understood that the terms such as "including," "comprising," and "having" specify the presence of stated features or components, but do not preclude the presence or addition of one or more other features or components.

In the following embodiments, when an area, a component, or the like is positioned on or above another part, the present disclosure includes not only a case in which the area, the component, or the like is positioned directly above the other part, but also a case in which other areas, other components, or the like may be positioned therebetween.

In the drawings, components may be exaggerated or reduced in size for convenience of description. For example, the size and thickness of each component shown in the drawing are arbitrarily shown for convenience of description, and thus the present disclosure is not necessarily limited to what is shown.

In the following embodiments, it will be understood that when an area, a component, or the like is referred to as being connected to another component, it may be directly connected to the other component or intervening components may also be present.

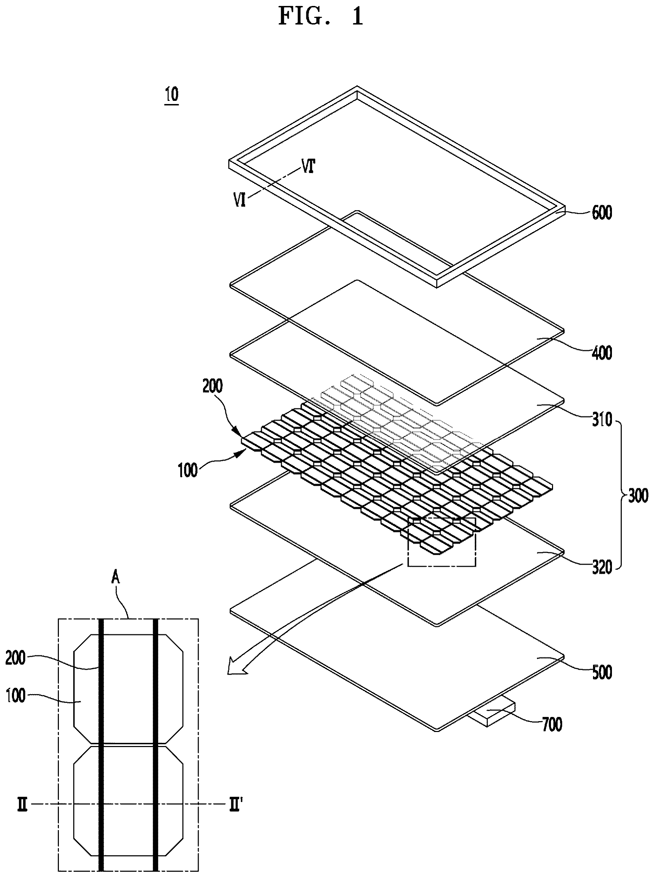

FIG. 1 is a schematic exploded perspective view illustrating a solar cell module 10 according to an embodiment of the present disclosure.

Referring to FIG. 1, the solar cell module 10 may include a plurality of cells 100, an electrode ribbon 200, a sealing unit 300, a protective member 400, a backsheet 500, a frame 600, and a junction box 700.

The solar cell module 10 may be manufactured by disposing and aligning the plurality of cells 100 in a preset pattern. The plurality of cells 100 may be electrically connected by the electrode ribbon 200.

In an embodiment, the cell 100 may be provided as a silicon-based solar cell. A silicon-based solar cell may be a type of the most widely used solar cell, may refer to a semiconductor device having a p-n junction, and may have a structure in which two types (p type and n type) of semiconductors with different electrical properties are stacked therein. The type or structure of the cell 100 is not limited, and other embodiments with modified internal structures or materials may also be applied.

The electrode ribbon 200 may include a conductive material to connect the plurality of cells 100 in series. The electrode ribbon 200 may output power generated in the cell 100 to the outside. The electrode ribbon 200 may be bonded and electrically connected to the cell 100.

In general, when the plurality of cells 100 are connected in series, a tabbing operation may be performed to connect a front bus electrode of one cell 100 to a rear bus electrode of an adjacent cell 100 by using the electrode ribbon 200. In the tabbing operation, high temperature heat may be applied to an outer sheath of the electrode ribbon 200 to melt the outer sheath and form an alloy with the bus electrode, thereby bonding the electrode ribbon 200 to the cell 100. For example, the electrode ribbon 200 may be made of a copper wire coated with solder (SnPb) or lead-free solder (SnAgCu). The bus electrode may be mainly made of a conductive adhesive or a conductive material that is similar thereto. However, one or more embodiments are not limited thereto, and one of various known structures may be applied as a connection structure between the cell 100 and the electrode ribbon 200.

The sealing unit 300 may seal the plurality of cells 100 and the electrode ribbon 200. The sealing unit 300 may include a first sealing material 310 and a second sealing material 320. The sealing unit 300 may be formed by integrating the first sealing material 310 and the second sealing material 320 through a lamination process in a state in which the first sealing material 310 and the second sealing material 320 are disposed on and below the cell 100, respectively. The sealing unit 300 may seal the cell 100 and the electrode ribbon 200 to prevent corrosion due to moisture penetration. In addition, the sealing unit 300 may be a filler for protecting the cell 100 from an external impact. For example, the sealing unit 300 may include a material such as ethylene vinyl acetate (EVA).

The protective member 400 may be disposed on an upper surface of the sealing unit 300 to protect a front surface of the cell 100. The protective member 400 may be made of a material having strength capable of protecting the cell 100 against AN external impact. The protective member 400 may be provided to have high light transmittance. For example, the protective member 400 may be made of glass. The glass may be tempered glass with high transmittance and an excellent damage prevention function.

The backsheet 500 may be disposed on a lower surface of the sealing unit 300 to protect a rear surface of the cell 100. The backsheet 500 may protect the cell 100 from the influence of an external environment. The backsheet 500 may block moisture from penetrating from the rear surface of the cell 100. In the drawing, an embodiment in which the backsheet 500 is formed in a single layer is shown, but one or more embodiments are not limited thereto. The backsheet 500 may have a multilayer structure as needed.

Hereinafter, for convenience of description, a combination of the sealing unit 300 configured to seal the plurality of cells 100 and the electrode ribbon 200, and the protective member 400 and the backsheet 500 respectively disposed on front and rear surfaces of the sealing unit 300 is referred to as a solar cell panel.

The frame 600 may be provided to surround an outer periphery of the solar cell panel. The frame 600 may cap a perimeter of a side surface of the solar cell panel. The frame 600 may be provided in a shape that wraps an edge of the solar cell panel. In this way, the frame 600 may fix a multilayer structure of the solar cell panel, thereby preventing the solar cell panel from being vertically or laterally twisted or separated.

The junction box 700 may be connected to the cell 100 through a wiring to receive electric charges from the cell 100. The junction box 700 may be installed and connected after the cell 100 and the electrode ribbon 200 are sealed with the sealing unit 300. The junction box 700 may include a wiring for outputting generated power to the outside. For example, the junction box 700 may have one side connected to the cell 100 and the other side connected to an inverter or the like.

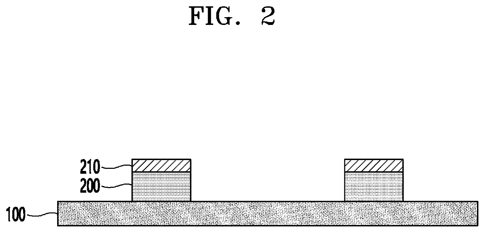

FIG. 2 is a view illustrating a cross section of the cell 100 and the electrode ribbon 200 of FIG. 1, which is taken along line II-II'.

Referring to FIG. 2, the electrode ribbon 200 may be disposed on a surface of the cell 100, and the electrode ribbon 200 may include a first indicator 210 of which a color changes according to a temperature change.

The first indicator 210 may be disposed on a surface of the electrode ribbon 200. As an example, the first indicator 210 may be formed by being applied onto the surface of the electrode ribbon 200. As another example, the first indicator 210 may be provided as a thin film and bonded to the surface of the electrode ribbon 200.

When the plurality of cells 100 produce electricity, while a current flows in the solar cell module 10, the cells 100 may spontaneously generate heat. When heat is generated in the cell 100, the heat may be transferred to the electrode ribbon 200 in contact with the cell 100. When a temperature of the electrode ribbon 200 rises, the first indicator 210 may detect a temperature change so that a color thereof may change. That is, the first indicator 210 may detect a temperature change of the solar cell module 10 due to the cell 100 generating heat.

The first indicator 210 may be made of a material of which a color changes according to a temperature. The first indicator 210 may include a material of which a color changes at a temperature that is greater than a preset reference temperature. Specifically, the first indicator 210 may include a thermochromic pigment.

The thermochromic pigment is a general term for pigments of which a color changes according to heat and mainly refers to a temperature-sensitive pigment which shows an intrinsic color at a reference temperature or less but is decolored to be transparent when a temperature rises. The thermochromic pigment is mainly classified into a reversible thermochromic pigment and an irreversible thermochromic pigment. The reversible thermochromic pigment returns to the original color thereof when a temperature drops after the reversible thermochromic pigment is discolored, but the irreversible thermochromic pigment does not return to the original color thereof when discolored once. As another type of thermochromic pigment, a reverse reversible temperature-sensitive pigment is transparent at a reference temperature or less and shows a different color when a temperature rises, unlike a typical temperature-sensitive pigment. In addition, when the thermochromic pigment is used together with a general pigment that forms a base color, the base color may be exposed in a temperature range in which the thermochromic pigment becomes transparent, and thus the thermochromic pigment may clearly exhibit thermochromism.

Accordingly, the first indicator 210 may be provided to detect various temperature change sections by including at least one thermochromic pigment or a thermochromic pigment and a general pigment.

According to an embodiment, a structure of the first indicator 210 may be provided as a single layer. The first indicator 210 may be manufactured by mixing a plurality of materials to be randomly dispersed inside the single layer. Specifically, the first indicator 210 may include a first pigment and a second pigment of different types so that the first pigment and the second pigment may be randomly dispersed inside the first indicator 210. At least one of the first pigment and the second pigment may be provided as a thermochromic pigment, and the other thereof may be provided as a different thermochromic pigment or a general pigment.

In another embodiment, the structure of the first indicator 210 may be provided by stacking a plurality of layers. The first indicator 210 may be manufactured such that a plurality of materials form each layer. Specifically, the first indicator 210 may include the first pigment and the second pigment of different types and thus may include a first layer including the first pigment and a second layer including the second pigment. At least one of the first pigment and the second pigment may be provided as a thermochromic pigment, and the other thereof may be provided as a different thermochromic pigment or a general pigment.

However, one or more embodiments are not limited thereto, and any structure may be applied as the structure of the first indicator 210 as long as the structure may be embedded with a plurality of pigment components therein and may exhibit a different color by other different colors when a thermochromic pigment among the pigment components changes color.

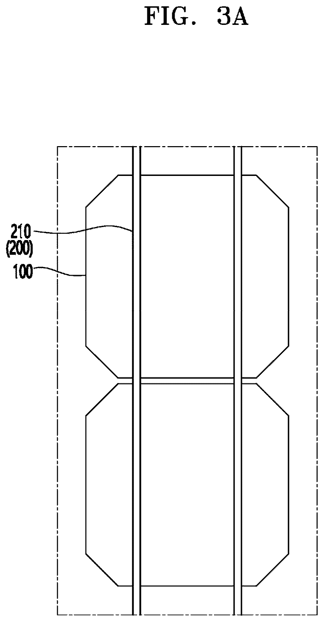

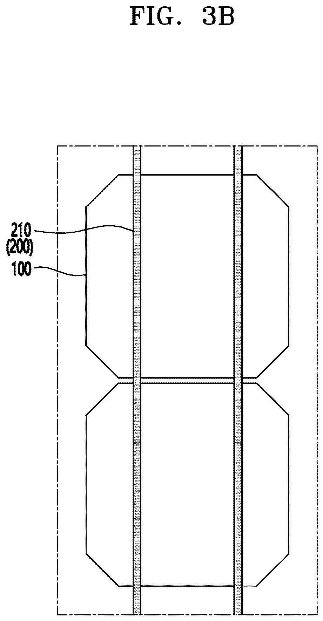

FIGS. 3A and 3B are views illustrating the cell 100 and the electrode ribbon 200 of FIG. 1. Specifically, FIG. 3A illustrates the cell 100 and the electrode ribbon 200 at room temperature. FIG. 3B shows the electrode ribbon 200 of which a color changes according to a temperature change.

Referring to FIGS. 2, 3A, and 3B, while the cell 100 normally operates to generate power, a temperature thereof may change, and a color of the first indicator 210 disposed outside the electrode ribbon 200 may change. While the color of the first indicator 210 changes, a user may visually check a color change of the electrode ribbon 200.

The first indicator 210 may exhibit a color change according to a temperature change in a plurality of temperature sections, and thus a user may check an operating state of the solar cell module 10 by using the color change of the electrode ribbon 200.

According to an embodiment, the first indicator 210 may exhibit a first color in a first temperature range and may exhibit a second color different from the first color in a second temperature range that is different from the first temperature range.

For example, the first indicator 210 may include one type of thermochromic pigment. The thermochromic pigment may exhibit the first color at room temperature and may change to the second color at a temperature that is greater than a preset reference temperature. The reference temperature may be set to a heat generation temperature at which the cell 100 normally operates to generate power.

In the first temperature range from room temperature to less than the reference temperature, the thermochromic pigment may not change color and thus may exhibit the first color. That is, the first indicator 210 may exhibit the first color when the cell 100 does not operate to generate power.

In the second temperature range exceeding the reference temperature, the thermochromic pigment may change to the second color. That is, the first indicator 210 may exhibit the second color when the cell 100 normally operates.

According to another embodiment, the first indicator 210 may exhibit the first color when the cell 100 normally operates, may exhibit the second color when the cell 100 does not operate, and may exhibit a third color when the cell 100 abnormally operates.

For example, the first indicator 210 may include a first thermochromic pigment and a second thermochromic pigment. The first thermochromic pigment may change color at a first reference temperature or more. The second thermochromic pigment may change color at a second reference temperature or more. The second reference temperature may be provided to be greater than the first reference temperature. The first reference temperature may be set to a heat generation temperature at which the cell 100 normally operates to generate power. The second reference temperature may be set to a hotspot generation temperature at which it is determined that the cell 100 abnormally operates to be overheated.

In the first temperature range from room temperature to less than the first reference temperature, the first thermochromic pigment and the second thermochromic pigment may not change color, and thus the first indicator 210 may exhibit the second color in which intrinsic colors of the first thermochromic pigment and the second thermochromic pigment are mixed. That is, the first indicator 210 may exhibit the second color when the cell 100 does not operate to generate power.

In the second temperature range that is greater than or equal to the first reference temperature and less than the second reference temperature, the first thermochromic pigment may change color, and the second thermochromic pigment may not change color so that the first indicator 210 may exhibit the first color that is different from the second color. That is, the first indicator 210 may exhibit the first color when the cell 100 normally operates.

In a third temperature range exceeding the second reference temperature, both the first thermochromic pigment and the second thermochromic pigment may change color so that the first indicator 210 may exhibit the third color that is different from the first color and the second color. That is, the first indicator 210 may exhibit the third color when the cell 100 abnormally operates, and a hotspot phenomenon occurs.

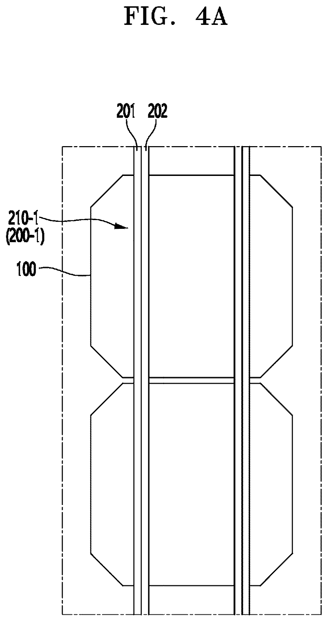

FIGS. 4A to 4C are views illustrating a cell 100 and an electrode ribbon 200-1 according to another embodiment.

Referring to FIGS. 4A to 4C, the electrode ribbon 200-1 may be divided into a first area 201 and a second area 202. A first indicator 210-1 may be provided to change to different colors in the first area 201 and the second area 202.

The first indicator 210-1 may change from the first color to the second color in one area of the electrode ribbon 200-1 and may change from the first color to a third color in another area of the electrode ribbon 200-1.

For example, the first indicator 210-1 may be divided into the first area 201 and the second area 202. The first area 201 may include a first thermochromic pigment, and the second area 202 may include a second thermochromic pigment.

The first thermochromic pigment may exhibit the first color at room temperature and may change to the second color at a temperature that is greater than or equal to a first reference temperature. The second thermochromic pigment may exhibit the first color at room temperature and may change to a third color at a temperature that is greater than or equal to a second reference temperature.

In this case, the second reference temperature may be provided to be greater than the first reference temperature. The first reference temperature may be set to a heat generation temperature at which the cell 100 normally operates to generate power. The second reference temperature may be set to a hotspot generation temperature at which it is determined that the cell 100 abnormally operates to be overheated.

In a first temperature range from room temperature to less than the first reference temperature, the first thermochromic pigment and the second thermochromic pigment may not change color so that both the first area 201 and the second area 202 of the first indicator 210-1 may exhibit the first color as shown in FIG. 4A. That is, the first indicator 210-1 may exhibit the first color in the entire area when the cell 100 does not operate to generate power.

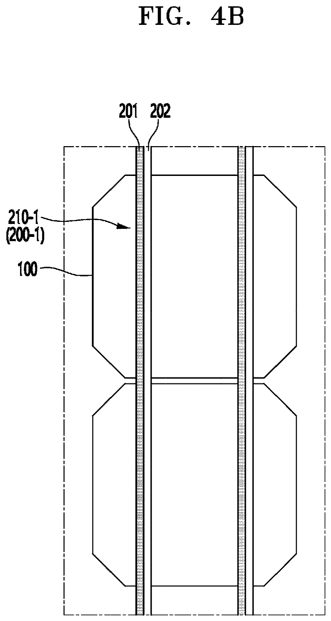

In a second temperature range from the first reference temperature to less than the second reference temperature, the first thermochromic pigment may change to the second color, and the second thermochromic pigment may not change color so that the first indicator 210-1 may exhibit the second color in the first area 201 and may exhibit the first color in the second area 202 as shown in FIG. 4B. That is, the first indicator 210-1 may partially change color when the cell 100 normally operates.

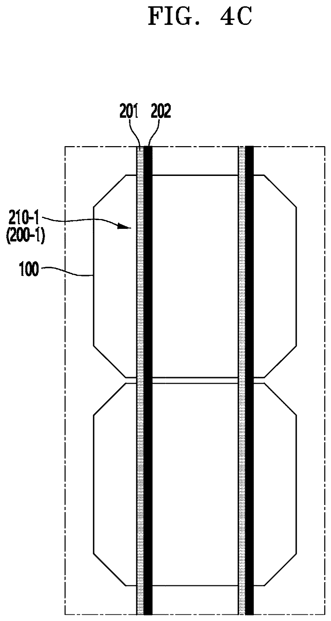

In a third temperature range exceeding the second reference temperature, both the first thermochromic pigment and the second thermochromic pigment change color so that the first indicator 210-1 may exhibit the second color in the first area 201 and may exhibit the third color in the second area 202 as shown in FIG. 4C. That is, the first indicator 210-1 may change color in the entire area when the cell 100 abnormally operates, and a hotspot phenomenon occurs.

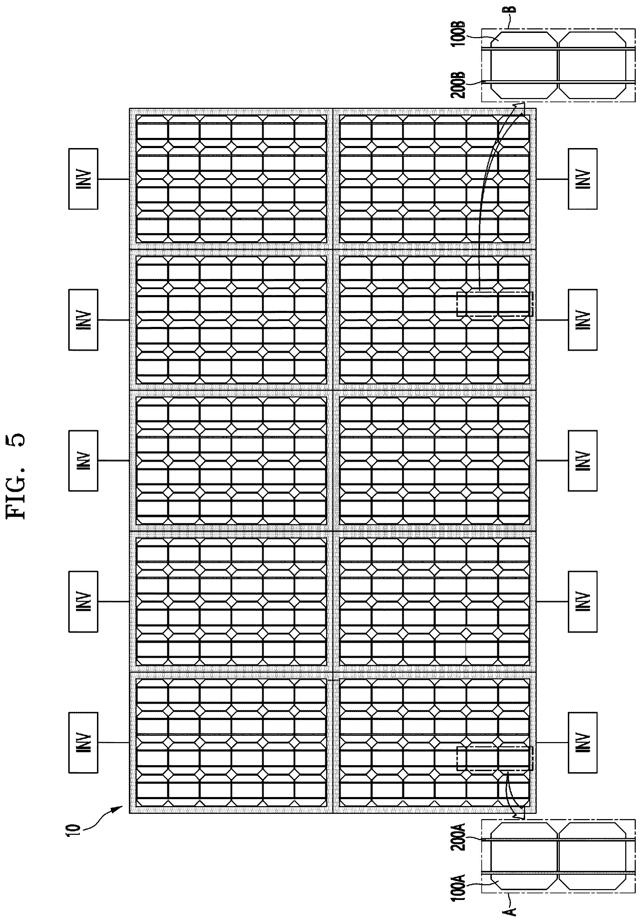

FIG. 5 is a view illustrating a solar cell array in which the plurality of solar cell modules 10 of FIG. 1 are arranged.

Referring to FIGS. 2 and 5, the plurality of solar cell modules 10 are connected and arranged in longitudinal and transverse directions to form the solar cell array, thereby constructing a single solar power generation facility.

Each solar cell module 10 may be connected to a module level power electronics (MLPE) device. For example, the solar cell module 10 may be connected to a microinverter, a direct current (DC) optimizer, or other power conversion device. Since the solar cell modules 10 and the MLPE device are connected one-to-one, power produced from one solar cell module 10 may be individually controlled by the MLPE device connected to a corresponding module. In FIG. 5, an embodiment in which the solar cell module 10 is connected to an inverter INV is shown.

According to an embodiment, the solar cell module 10 may include an electrode ribbon 200 including a first indicator 210 of which a color changes according to a temperature.

Part A of FIG. 5 represents a cell 100A and an electrode ribbon 200A of a normally operating module, and part B represents a cell 100B and an electrode ribbon 200B of an abnormally operating module.

When the solar cell module 10 normally generates power, the cell 100A may spontaneously generate heat while producing electricity. Accordingly, a temperature of the solar cell module 10 may change due to the influence of sunlight or air temperature as well as a heat generation temperature of the cell 100A and other components caused by power generation.

On the other hand, as in part B of FIG. 5, when the solar cell module 10 does not normally generate power, the cell 100B and other components may not generate heat due to power generation. Thus, a temperature of the solar cell module 10 may change only due to the influence of sunlight or air temperature.

Therefore, when a failure occurs in one of the plurality of solar cell modules 10 included in the solar cell array, a temperature difference may be formed between a normally operating module and a failed module. A first indicator 210A (not shown) of a module that normally operates and a first indicator 210B (not shown) of a module that does not operate may exhibit different colors. A user may visually and easily identify a failed module in the solar cell array.

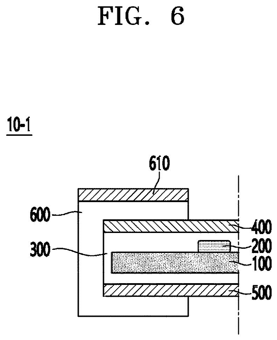

FIG. 6 is a view illustrating a cross section of a solar cell module 10-1 according to another embodiment, which is taken along line VI-VI' of FIG. 1.

Referring to FIG. 6, a solar cell module 10-1 may include a plurality of cells 100, an electrode ribbon 200, a sealing unit 300, a protective member 400, a backsheet 500, and a frame 600. The frame 600 may include a second indicator 610 of which a color changes according to a temperature change. Since the contents of other components of the solar cell module 10-1 are the same as the technical contents described above with reference to FIG. 1, the following description will be focused on the frame 600 and the second indicator 610.

The frame 600 may be provided to facilitate the installation of the solar cell module 10-1 or protect the solar cell module 10-1. In general, the solar cell module 10-1 may be exposed to an outdoor environment on which sunlight is directly incident for a long period of time, and in particular, the frame 600 may be positioned at an outermost side of a module structure and thus may be exposed to high temperature or moisture due to a weather phenomenon or may receive other external forces. Accordingly, the frame 600 may be made of a material having excellent durability and may be usually made of a metal material. For example, the frame 600 may include an aluminum alloy. When the frame 600 is made of metal, the frame 600 may have excellent heat resistance not to be damaged by heat even when exposed to high temperature and may have excellent thermal conductivity to easily receive heat from other adjacent parts.

As illustrated in FIG. 6, the frame 600 may include the second indicator 610 which is in contact with an outer edge of the sealing unit 300 sealing the cell 100 and the electrode ribbon 200 and of which a color changes according to a temperature change.

The second indicator 610 may be disposed on a surface of the frame 600. As an example, the second indicator 610 may be formed by being applied onto the surface of the frame 600. As another example, the second indicator 610 may be provided as a thin film and bonded to the surface of the frame 600.

When the plurality of cells 100 produce electricity, while a current flows in the solar cell module 10-1, the cells 100 may spontaneously generate heat. When heat is generated in the cell 100, the heat may be transferred to the sealing unit 300 that fills a periphery of the cell 100. When a temperature of the sealing unit 300 rises, the second indicator 610 may detect a temperature change so that a color thereof may change. That is, the second indicator 610 may detect a temperature change of the solar cell module 10-1 due to the cell 100 generating heat.

The second indicator 610 may be made of a material of which a color changes according to a temperature. The second indicator 610 may include a material of which a color changes at a temperature that is greater than a preset reference temperature. Specifically, the second indicator 610 may include a thermochromic pigment. The second indicator 610 may be provided to detect various temperature change sections by including at least one thermochromic pigment or a thermochromic pigment and a general pigment.

According to an embodiment, a structure of the second indicator 610 may be provided as a single layer. The second indicator 610 may be manufactured by mixing a plurality of materials to be randomly dispersed inside the single layer. Specifically, the second indicator 610 may include a first pigment and a second pigment of different types so that the first pigment and the second pigment may be randomly dispersed inside the second indicator 610. At least one of the first pigment and the second pigment may be provided as a thermochromic pigment, and the other thereof may be provided as a different thermochromic pigment or a general pigment.

In another embodiment, the structure of the second indicator 610 may be provided by stacking a plurality of layers. The second indicator 610 may be manufactured such that a plurality of materials form each layer. Specifically, the second indicator 610 may include the first pigment and the second pigment of different types and thus may include a first layer including the first pigment and a second layer including the second pigment. At least one of the first pigment and the second pigment may be provided as a thermochromic pigment, and the other thereof may be provided as a different thermochromic pigment or a general pigment.

However, one or more embodiments are not limited thereto, and any structure may be applied as the structure of the second indicator 610 as long as the structure may be embedded with a plurality of pigment components therein and may exhibit a different color by other different colors when a thermochromic pigment among the pigment components changes color.

Referring again to FIGS. 1 and 6, while the cell 100 normally operates to generate power, a temperature thereof may change, and the color of the second indicator 610 disposed outside the frame 600 may change. As the color of the second indicator 610 changes, a user may visually check a color change of the frame 600.

The second indicator 610 may exhibit a color change according to a temperature change in a plurality of temperature sections, and thus a user may check an operating state of the solar cell module 10-1 by using the color change of the frame 600.

According to an embodiment, the second indicator 610 may exhibit a first color in a first temperature range and may exhibit a second color different from the first color in a second temperature range that is different from the first temperature range.

For example, the second indicator 610 may include one type of thermochromic pigment. The thermochromic pigment may exhibit the first color at room temperature and may change to the second color at a temperature that is greater than a preset reference temperature. The reference temperature may be set to a heat generation temperature at which the cell 100 normally operates to generate power.

In the first temperature range from room temperature to less than the reference temperature, the thermochromic pigment may not change color and thus may exhibit the first color. That is, the second indicator 610 may exhibit the first color when the cell 100 does not operate to generate power.

In the second temperature range exceeding the reference temperature, the thermochromic pigment may change to the second color. That is, the second indicator 610 may exhibit the second color when the cell 100 normally operates.

According to another embodiment, the second indicator 610 may exhibit the first color when the cell 100 normally operates, may exhibit the second color when the cell 100 does not operate, and may exhibit a third color when the cell 100 abnormally operates.

For example, the second indicator 610 may include a first thermochromic pigment and a second thermochromic pigment. The first thermochromic pigment may change color at a first reference temperature or more. The second thermochromic pigment may change color at a second reference temperature or more. The second reference temperature may be provided to be greater than the first reference temperature. The first reference temperature may be set to a heat generation temperature at which the cell 100 normally operates to generate power. The second reference temperature may be set to a hotspot generation temperature at which it is determined that the cell 100 abnormally operates to be overheated.

In the first temperature range from room temperature to less than the first reference temperature, the first thermochromic pigment and the second thermochromic pigment may not change color, and thus the second indicator 610 may exhibit the second color in which intrinsic colors of the first thermochromic pigment and the second thermochromic pigment are mixed. That is, the second indicator 610 may exhibit the second color when the cell 100 does not operate to generate power.

In the second temperature range from the first reference temperature to less than the second reference temperature, the first thermochromic pigment may change color, and the second thermochromic pigment may not change color so that the second indicator 610 may exhibit the first color that is different from the second color. That is, the second indicator 610 may exhibit the second color when the cell 100 normally operates.

In a third temperature range exceeding the second reference temperature, both the first thermochromic pigment and the second thermochromic pigment may change color so that the second indicator 610 may exhibit the third color that is different from the first color and the second color. That is, the second indicator 610 may exhibit the third color when the cell 100 abnormally operates, and a hotspot phenomenon occurs.

According to another embodiment, the second indicator 610 may change from the first color to the second color in one area of the frame 600 and may change from the first color to the third color in another area of the frame 600.

For example, the second indicator 610 may be divided into a first area and a second area. The first area may include the first thermochromic pigment, and the second area may include the second thermochromic pigment.

The first thermochromic pigment may exhibit the first color at room temperature and may change to the second color at a temperature that is greater than or equal to the first reference temperature. The second thermochromic pigment may exhibit the first color at room temperature and may change to the third color at a temperature that is greater than or equal to the second reference temperature.

In this case, the second reference temperature may be provided to be greater than the first reference temperature. The first reference temperature may be set to a heat generation temperature at which the cell 100 normally operates to generate power. The second reference temperature may be set to a hotspot generation temperature at which it is determined that the cell 100 abnormally operates to be overheated.

In the first temperature range from room temperature to less than the first reference temperature, the first thermochromic pigment and the second thermochromic pigment may not change color, and thus both the first thermochromic pigment and the second thermochromic pigment of the second indicator 610 may exhibit the first color. That is, the second indicator 610 may exhibit the first color in the entire area when the cell 100 does not operate to generate power.

In the second temperature range from the first reference temperature to less than the second reference temperature, the first thermochromic pigment may change to the second color, and the second thermochromic pigment may not change color so that the second indicator 610 may exhibit the second color in the first area and may exhibit the first color in the second area. That is, the second indicator 610 may partially change color when the cell 100 normally operates.

In the third temperature range exceeding the second reference temperature, both the first thermochromic pigment and the second thermochromic pigment may change color so that the second indicator 610 may exhibit the second color in the first area and may exhibit the third color. That is, the second indicator 610 may change color in the entire area when the cell 100 abnormally operates, and a hotspot phenomenon occurs.

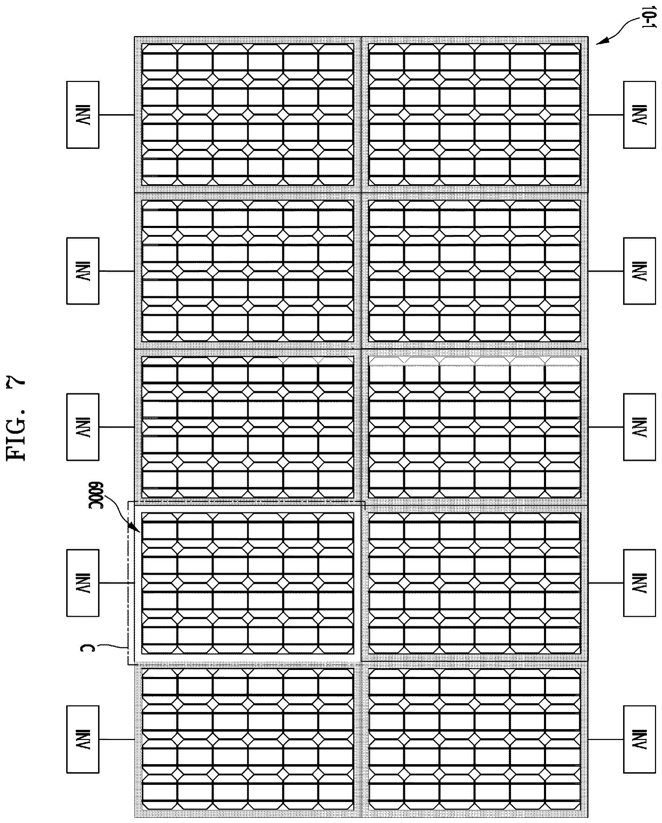

FIG. 7 is a view illustrating a solar cell array in which a plurality of solar cell modules 10-1 of FIG. 6 are arranged.

Referring to FIGS. 6 and 7, the plurality of solar cell modules 10-1 are connected and arranged in longitudinal and transverse directions to form the solar cell array, thereby constructing a single solar power generation facility.

Each solar cell module 10-1 may be connected to an MLPE device. For example, the solar cell module 10-1 may be connected to a microinverter, a DC optimizer, or other power conversion device.

Since the solar cell modules 10-1 and the MLPE device are connected one-to-one, power produced from one solar cell module 10-1 may be individually controlled by the MLPE device connected to a corresponding module. In FIG. 7, an embodiment in which the solar cell module 10-1 is connected to an inverter INV is shown.

According to an embodiment, the solar cell module 10-1 may include a frame 600 including a second indicator 610 of which a color changes according to a temperature.

Part C of FIG. 7 represents a module that abnormally operates, and the rest represents modules that all normally operate.

When the solar cell module 10-1 normally generates power, a cell 100 may spontaneously generate heat while producing electricity. Accordingly, a temperature of the solar cell module 10-1 may change due to the influence of sunlight or air temperature as well as a heat generation temperature of the cell 100 and other components caused by power generation.

On the other hand, as in part C of FIG. 7, when the solar cell module 10-1 does not normally generate power, heat is not generated, and a temperature of the solar cell module 10-1 may change only due to the influence of sunlight or air temperature.

Therefore, when a failure occurs in one of the plurality of solar cell modules 10-1 included in the solar cell array, a temperature difference may be formed between a normally operating module and a failed module. A second indicator 610 (not shown) of a module that normally operates and a second indicator 610C (not shown) of a module that does not operate may exhibit different colors. A user may visually and easily identify a failed module in the solar cell array.

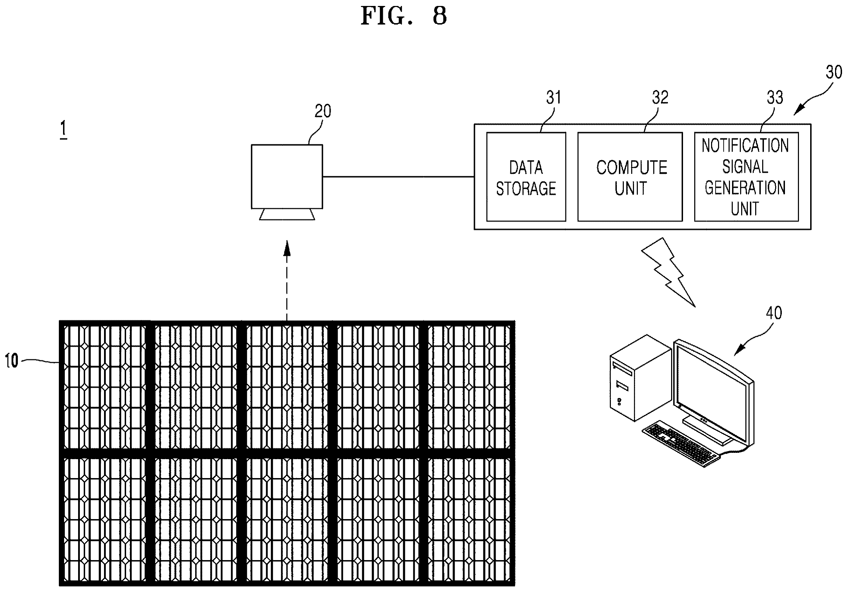

FIG. 8 is a view illustrating a solar cell power generation system 1 including the solar cell module 10 of FIG. 1.

Referring to FIGS. 1, 5, 7, and 8, the solar cell power generation system 1 may include a plurality of solar cell modules 10, an imaging device 20, a controller 30, and an input display device 40.

In the solar cell power generation system 1, the plurality of solar cell modules 10 are provided as solar cell arrays arranged at certain intervals, and solar power generation may be performed in the solar cell arrays.

When an abnormal module having a failure or defect is present in the solar cell array, as in the embodiments shown in FIG. 5 or 7, in the abnormal module, a color of a first indicator 210 or a color of a second indicator 610 may appear differently from those of surrounding normally operating modules.

The imaging device 20 may photograph the solar cell array to generate an image. The imaging device 20 may photograph the entire area or a partial area of the solar cell array to generate an image. The image generated by the imaging device 20 may be transmitted to the controller 30.

When the controller 30 analyzes the image received from the imaging device 20, and a color value of a portion of the image corresponding to the first indicator 210 or the second indicator 610 is outside a pre-input suitable criterion range, the controller 30 may generate a notification signal for an abnormal module.

The controller 30 may include a data storage 31, a compute unit 32, and a notification signal generation unit 33.

The data storage 31 may store a color value range of a suitable criterion, which is input from the input display device 40, and information about an analysis target range in the image. In addition, the data storage 31 may store the image received from the imaging device 20.

The compute unit 32 may calculate a color value for each pixel from the image. The compute unit 32 may extract only a color value in an analysis target range from the image. The compute unit 32 may compare the extracted color value with a preset suitable criterion range. Accordingly, the compute unit 32 may calculate position information about pixels, which have unsuitable color values, in the image.

The notification signal generation unit 33 may designate an abnormal range in the image based on the position information calculated by the compute unit 32 and thus may generate a notification signal for the occurrence of an abnormal module. The notification signal generation unit 33 may transmit the generated notification signal to the input display device 40.

The input display device 40 may display the notification signal, which is transmitted from the notification signal generation unit 33, on a screen. By using the notification signal, a user may identify a position of a module 10 having a failure or defect in the solar cell array, thereby quickly replacing or repairing the module 10.

The present disclosure has been described with reference to embodiments shown in the accompanying drawings, but this is merely illustrative, and those skilled in the art will understand that various modifications and other equivalent embodiments are possible therefrom. Therefore, the true scope of the present disclosure should be determined only by the appended claims.

## Claims

1. A solar cell module comprising:
a plurality of cells;
an electrode ribbon configured to connect the plurality of cells;
a sealing unit configured to seal the plurality of cells;
a frame disposed on one surface of the sealing unit; and
a backsheet configured to support another surface of the sealing unit,
wherein the electrode ribbon comprises a first indicator of which a color changes according to a temperature change of the plurality of cells.

2. The solar cell module of claim 1, wherein the first indicator exhibits a first color in a first temperature range and exhibits a second color different from the first color in a second temperature range different from the first temperature range.

3. The solar cell module of claim 1, wherein the first indicator is applied onto a surface of the electrode ribbon.

4. The solar cell module of claim 1, wherein the first indicator exhibits a first color when the cells normally operate, exhibits a second color when the cells do not operate, and exhibits a third color when the cells abnormally operate.

5. The solar cell module of claim 1, wherein the first indicator changes from a first color to a second color in one area of the electrode ribbon and changes from the first color to a third color in another area of the electrode ribbon.

6. The solar cell module of claim 1, further comprising a module level power electronics (MLPE) device connected to the cell.

7. A solar cell module comprising:
a plurality of cells;
an electrode ribbon configured to connect the plurality of cells;
a sealing unit configured to seal the plurality of cells;
a frame disposed on one surface of the sealing unit; and
a backsheet configured to support another surface of the sealing unit,
wherein the frame comprises a second indicator of which a color changes according to a temperature change of the plurality of cells.

8. The solar cell module of claim 7, wherein the second indicator exhibits a first color in a first temperature range and exhibits a second color different from the first color in a second temperature range different from the first temperature range.

9. The solar cell module of claim 7, wherein the second indicator is applied onto a surface of the frame.

10. The solar cell module of claim 7, wherein the second indicator exhibits a first color when the cells normally operate, exhibits a second color when the cells do not operate, and exhibits a third color when the cells abnormally operate.

11. The solar cell module of claim 7, wherein the second indicator changes from a first color to a second color in one area of the frame and changes from the first color to a third color in another area of the frame.

12. The solar cell module of claim 7, further comprising a module level power electronics (MLPE) device connected to the cell.
